# EUROPEAN PATENT APPLICATION

(11) **EP 3 886 192 A1**
(43) Date of publication of application: **29.09.2021**
(21) Application number: 20777047.0
(22) Date of filing: 25.03.2020
(51) Int. Cl.: H01L 51/44

(54) **PHOTOELECTRIC CONVERSION ELEMENT, METHOD FOR PRODUCING PHOTOELECTRIC CONVERSION ELEMENT, AND SOLAR CELL**

(30) Priority: 26.03.2019 JP 2019058643
(71) Applicant: Sekisui Chemical Co., Ltd., Osaka-shi, Osaka 530-0047 (JP)
(72) Inventor: OKAMOTO, Masako, Mishima-gun, Osaka 618-0021 (JP); SHINOHARA, Takamichi, Mishima-gun, Osaka 618-0021 (JP); ORII, Shun, Mishima-gun, Osaka 618-0021 (JP); HAYAKAWA, Akinobu, Mishima-gun, Osaka 618-0021 (JP)
(74) Representative: Cabinet Beau de Loménie
(86) International application number: PCT/JP2020/013230
(87) International publication number: WO 2020/196588

(57) **Abstract**

The present invention aims to provide a photoelectric conversion element having high photoelectric conversion efficiency, a method for producing the photoelectric conversion element, and a solar cell including the photoelectric conversion element. Provided is a photoelectric conversion element containing a perovskite compound represented by the formula AMX wherein A represents an organic base compound and/or an alkali metal, M represents a lead or tin atom, and X is a halogen atom, the photoelectric conversion element having an intensity ratio of a nitrate ion to a halogen ion (NO₃/X) of 0.0010 or more and less than 0.2000 as determined by TOF-SIMS measurement.

## Description

### TECHNICAL FIELD

The present invention relates to a photoelectric conversion element having high photoelectric conversion efficiency, a method for producing the photoelectric conversion element, and a solar cell including the photoelectric conversion element.

### BACKGROUND ART

Solar cells including a laminate (photoelectric conversion element) having an N-type semiconductor layer and a P-type semiconductor layer disposed between opposing electrodes have been conventionally developed. Such solar cells generate photocarriers (electron-hole pairs) by photoexcitation so that electrons and holes move through the N-type semiconductor and the P-type semiconductor, respectively, to create an electric field.

Most solar cells currently in practical use are inorganic solar cells which are produced using inorganic semiconductors made of silicon or the like. The inorganic solar cells, however, are utilized only in a limited range because their production is costly and upsizing thereof is difficult. Therefore, organic solar cells produced using organic semiconductors instead of inorganic semiconductors (see Patent Literatures 1 and 2, for example) and organic-inorganic solar cells produced using organic semiconductors and inorganic semiconductors in combination have received attention.

Fullerene is used in most organic solar cells and organic-inorganic solar cells. Fullerene is known to function mainly as an N-type semiconductor. For example, Patent Literature 1 discloses a semiconductor heterojunction film formed using an organic compound serving as a P-type semiconductor, and a fullerene. Fullerene, however, is known to be responsible for degradation of organic solar cells or organic-inorganic solar cells produced using the fullerene (see Non-Patent Literature 1, for example). Thus, a material that can replace fullerene is desired.

Recently, photoelectric conversion materials having a perovskite structure containing lead, tin, or the like as a central metal, called organic-inorganic hybrid semiconductors, have been found and proved to have high photoelectric conversion efficiency (see Non-Patent Literature 2, for example). In recent years, however, the competition to increase the photoelectric conversion efficiency in the solar cell field has intensified, creating a demand for a solar cell having higher photoelectric conversion efficiency.

### CITATION LIST

### - Patent Literature

Patent Literature 1: JP 2006-344794 A
Patent Literature 2: JP 4120362 B

### - Non-Patent Literature

Non-Patent Literature 1: Reese et al., Adv. Funct. Mater., 20, 3476-3483 (2010)
Non-Patent Literature 2: M. M. Lee et al., Science, 338, 643-647 (2012)

### SUMMARY OF INVENTION

### - Technical problem

The present invention aims to provide a photoelectric conversion element having high photoelectric conversion efficiency, a method for producing the photoelectric conversion element, and a solar cell including the photoelectric conversion element.

### - Solution to problem

The present invention relate to a photoelectric conversion element containing a perovskite compound represented by the formula AMX wherein A represents an organic base compound and/or an alkali metal, M represents a lead or tin atom, and X is a halogen atom, the photoelectric conversion element having an intensity ratio of a nitrate ion to a halogen ion (NO₃/X) of 0.0010 or more and less than 0.2000 as determined by TOF-SIMS measurement.

The present invention is described in detail below.

The present inventors made intensive studies to find out that adding nitrate ions to an organic-inorganic perovskite compound improves the photoelectric conversion efficiency. The inventors thus completed the present invention.

The photoelectric conversion element of the present invention contains a perovskite compound represented by the formula AMX wherein A represents an organic base compound and/or an alkali metal, M represents a lead or tin atom, and X represents a halogen atom.

A solar cell including the photoelectric conversion element that contains the perovskite compound is also referred to as an organic-inorganic hybrid solar cell.

The use of the perovskite compound as the material of the photoelectric conversion element can improve the photoelectric conversion efficiency.

A in the formula represents an organic base compound and/or an alkali metal.

Specific examples of the organic base compound include methylamine, ethylamine, propylamine, butylamine, pentylamine, hexylamine, dimethylamine, diethylamine, dipropylamine, dibutylamine, dipentylamine, dihexylamine, trimethylamine, triethylamine, tripropylamine, tributylamine, tripentylamine, trihexylamine, ethylmethylamine, methylpropylamine, butylmethylamine, methylpentylamine, hexylmethylamine, ethylpropylamine, ethylbutylamine, formamidine, acetoamidine, guanidine, imidazole, azole, pyrrole, aziridine, azirine, azetidine, azete, azole, imidazoline, carbazole and their ions (e.g., methylammonium(CH₃NH₃)), and phenethylammonium. Among them, preferred are methylamine, ethylamine, propylamine, butylamine, pentylamine, hexylamine, formamidine, acetoamidine and their ions, and phenethylammonium, and more preferred are methylamine, ethylamine, propylamine, formamidine and their ions.

Examples of the alkali metal include lithium, sodium, potassium, rubidium, and cesium. In particular, potassium is preferred.

M in the formula represents a metal atom, and is lead or tin. In particular, M is preferably lead. These metal atoms may be used alone or in combination of two or more thereof.

X in the formula represents a halogen atom. Examples thereof include chlorine, bromine, iodine, sulfur, and selenium. These halogen atoms may be used alone or in combination of two or more. The perovskite compound containing halogen in the structure is soluble in an organic solvent and is usable in an inexpensive printing method or the like. In particular, X is preferably iodine because it allows the perovskite compound to have a narrower energy band gap.

The perovskite compound preferably has a cubic crystal structure where the metal atom M is placed at the body center, the organic base compound or alkali metal A is placed at each vertex, and the halogen atom X is placed at each face center.

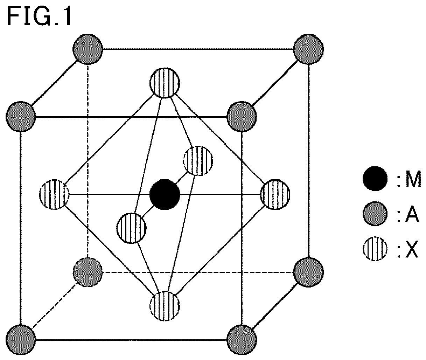

Fig. 1 is a schematic view illustrating an exemplary crystal structure of the perovskite compound having a cubic crystal structure where the metal atom M is placed at the body center, the organic base compound or alkali metal A is placed at each vertex, and the halogen atom X is placed at each face center. Although the details are not clear, it is presumed that this structure allows the octahedron in the crystal lattice to change its orientation easily, which enhances the mobility of electrons in the perovskite compound, improving the photoelectric conversion efficiency.

The perovskite compound is preferably a crystalline semiconductor. The crystalline semiconductor means a semiconductor whose scattering peak can be detected by the measurement of X-ray scattering intensity distribution. When the perovskite compound is a crystalline semiconductor, the mobility of electrons in the perovskite compound is enhanced, improving the photoelectric conversion efficiency.

The degree of crystallinity can also be evaluated as an index of crystallization. The degree of crystallinity can be determined by separating a crystalline substance-derived scattering peak from an amorphous portion-derived halo, which are detected by X-ray scattering intensity distribution measurement, by a fitting technique, determining the respective intensity integrals, and calculating the proportion of the crystalline portion to the whole.

The lower limit of the degree of crystallinity of the perovskite compound is preferably 30%. When the degree of crystallinity is 30% or higher, the mobility of electrons in the perovskite compound is enhanced, improving the photoelectric conversion efficiency. The lower limit of the degree of crystallinity is more preferably 50%, still more preferably 70%.

Examples of the method for increasing the degree of crystallinity of the perovskite compound include thermal annealing, irradiation with strong-intensity light, such as laser, and plasma irradiation.

The photoelectric conversion element of the present invention may further contain an organic semiconductor or an inorganic semiconductor, in addition to the perovskite compound, as long as the effects of the present invention are not impaired. The organic semiconductor or inorganic semiconductor herein may serve as a hole transport layer or an electron transport layer, respectively.

Examples of the organic semiconductor include compounds having a thiophene skeleton, such as poly(3-alkylthiophene). The examples also include conductive polymers having a poly-p-phenylenevinylene skeleton, a polyvinylcarbazole skeleton, a polyaniline skeleton, a polyacetylene skeleton, or the like. The examples further include: compounds having a phthalocyanine skeleton, a naphthalocyanine skeleton, a pentacene skeleton, a porphyrin skeleton such as a benzoporphyrin skeleton, a spirobifluorene skeleton or the like; and carbon-containing materials such as carbon nanotube, graphene, and fullerene, each of which may be surface-modified.

Examples of the inorganic semiconductor include titanium oxide, zinc oxide, indium oxide, tin oxide, gallium oxide, tin sulfide, indium sulfide, zinc sulfide, CuSCN, CU₂O, CuI, MoO₃, V₂O₅, WO₃, MoS₂, MoSe₂, and Cu₂S.

The photoelectric conversion element of the present invention containing the perovskite compound and the organic semiconductor or inorganic semiconductor may be a laminate in which a thin-film organic semiconductor or inorganic semiconductor part and a thin-film perovskite compound part are stacked, or may be a composite film in which an organic semiconductor or inorganic semiconductor part and a perovskite compound part are combined. The laminate is preferred from the viewpoint of a simple production process. The composite film is preferred from the viewpoint of improvement in charge separation efficiency in the organic semiconductor or the inorganic semiconductor.

The lower limit of the thickness of the thin-film perovskite compound part is preferably 5 nm and the upper limit thereof is preferably 5,000 nm. When the thickness is 5 nm or more, the thin-film perovskite compound part can sufficiently absorb light, enhancing the photoelectric conversion efficiency. When the thickness is 5,000 nm or less, formation of a region which fails to achieve charge separation can be reduced, improving the photoelectric conversion efficiency. The lower limit of the thickness is more preferably 10 nm and the upper limit thereof is more preferably 1,000 nm. The lower limit of the thickness is still more preferably 20 nm and the upper limit thereof is still more preferably 500 nm.

When the photoelectric conversion element of the present invention is a composite film in which an organic semiconductor or inorganic semiconductor part and a perovskite compound part are combined, the lower limit of the thickness of the composite film is preferably 30 nm and the upper limit thereof is preferably 3,000 nm. When the thickness is 30 nm or more, the composite film can sufficiently absorb light, enhancing the photoelectric conversion efficiency. When the thickness is 3,000 nm or less, charges easily reach the electrodes, enhancing the photoelectric conversion efficiency. The lower limit of the thickness is more preferably 40 nm and the upper limit thereof is more preferably 2,000 nm. The lower limit is still more preferably 50 nm and the upper limit is still more preferably 1,000 nm.

The photoelectric conversion element of the present invention has an intensity ratio of a nitrate ion to a halogen ion (NO₃/X) of 0.0010 or more and less than 0.2000 as determined by TOF-SIMS measurement.

In an organic-inorganic perovskite compound produced by a usual method, a small amount of nitrate ions may remain as impurities. Such impurities are usually removed as much as possible because they cause a decrease in the photoelectric conversion efficiency. However, the present inventors have found out that, surprisingly, actively adding nitrate ions can improve the photoelectric conversion efficiency of the resulting photoelectric conversion element. Note that the above NO₃/X value is unachievable by a photoelectric conversion element containing an organic-inorganic perovskite compound produced by a usual method.

For further improvement of the photoelectric conversion efficiency, the NO₃/X is preferably 0.0030 or more, more preferably 0.0060, still more preferably 0.0100 or more. The NO₃/X is also preferably less than 0.1000, more preferably less than 0.0600, still more preferably less than 0.0300.

The above NO₃/X may be satisfied by, for example, a method of increasing the amount of metal nitrate used in production of the metal halide, or a method of adding metal nitrate to a metal halide solution used in production of the perovskite compound.

Time-of-flight secondary ion mass spectrometry (TOF-SIMS) is a technique that irradiates a solid sample with an ion (primary ion) beam and performs mass separation of the ions (secondary ions) discharged from the surface based on the difference in time-of-flight (time-of-flight is proportional to the square root of the weight). TOF-SIMS can detect, with high detection sensitivity, information of elements or molecular spieces present in a region within 1 nm in the thickness direction from the sample surface. The analysis device used for TOF-SIMS may be "TOF-SIMS5" produced by ION-TOF GmbH. The above ion intensity ratio can be determined by measurement at 25 keV using a Bi₃⁺ ion gun as a primary ion source for measurement.

The photoelectric conversion element of the present invention preferably has an intensity ratio of a potassium ion to a lead or tin ion (K/M) of 0.4 or more and less than 2.0 as determined by the TOF-SIMS measurement.

The perovskite compound containing potassium in an amount satisfying the above K/M range can further improve the photoelectric conversion efficiency. For even further improvement of the photoelectric conversion efficiency, the lower limit of the K/M is more preferably 0.5, still more preferably 1.0 and the upper limit thereof is more preferably 1.8, still more preferably 1.5. The above K/M may be satisfied by, for example, a method of increasing the amount of potassium halide used in production of the metal halide, or a method of adding potassium halide to a metal halide solution used in production of the perovskite compound.

In the photoelectric conversion element of the present invention, preferably, the K/M is 0.8 or more and the NO₃/X is 0.0030 or more as determined by the TOF-SIMS measurement.

The photoelectric conversion element satisfying the above K/M range and NO₃/X range can have further improved photoelectric conversion efficiency. For even further improvement of the photoelectric conversion efficiency, the lower limit of the NO₃/X is preferably 0.0060, more preferably 0.0100 and the upper limit thereof is preferably 0.1000, more preferably 0.0500. The lower limit of the K/M is more preferably 0.9, still more preferably 1.0 and the upper limit thereof is more preferably 1.8, still more preferably 1.5.

The photoelectric conversion element of the present invention may be produced by, for example, forming a film from a solution containing a metal nitrate and a metal halide and forming, on the film, a film from a solution containing a halide of an organic base compound or an alkali metal, followed by heating treatment.

The present invention also encompasses a method for producing the photoelectric conversion element of the present invention, including: a first film forming step of forming a first film from a mixed solution (first solution) that contains a metal nitrate represented by MNO₃ wherein M is a lead or tin atom and a metal halide represented by MX wherein M is a lead or tin atom and X is a halogen atom; a second film forming step of forming a second film on the first film from a solution (second solution) of AX wherein A represents an organic base compound or an alkali metal and X is a halogen atom; and a step of performing heating treatment after the second film forming step.

In the method for producing the photoelectric conversion element of the present invention, first, a first film forming step is performed. In this step, a first film is formed from a mixed solution (first solution) that contains a metal nitrate represented by MNO₃ wherein M is a lead or tin atom and a metal halide represented by MX wherein M is a lead or tin atom and X is a halogen atom.

The use of the metal nitrate in addition to the metal halide, which is usually used in production of a perovskite compound, enables introduction of nitrate ions into the resulting photoelectric conversion element in an amount satisfying the above NO₃/X range.

The films may be formed by a printing method, for example. The use of a printing method enables easy formation of a large-area photoelectric conversion element. Examples of the printing method include a spin coating method and a casting method. Examples of the method using the printing method include a roll-to-roll method.

The amount of the metal nitrate in the first solution is preferably 0.1% by weight or more and less than 5.0% by weight.

When the amount of the metal nitrate is within the above range, the amount of nitrate ions in the resulting photoelectric conversion element can be easily adjusted to satisfy the above NO₃/X range. The amount of the metal nitrate is more preferably 0.2% by weight or more, still more preferably 0.3% by weight or more, and more preferably less than 2.0% by weight, still more preferably less than 1.0% by weight.

The first solution preferably contains a potassium halide represented by KX wherein X is a halogen atom.

The first solution containing the KX can introduce potassium atoms in the resulting photoelectric conversion element, thus further improving the photoelectric conversion efficiency.

The amount of the potassium halide in the first solution is preferably 0.1% by weight or more and less than 5.0% by weight.

When the amount of the potassium halide is within the above range, the amount of potassium atoms in the resulting photoelectric conversion element can be easily adjusted to satisfy the above K/M range. The amount of the potassium halide in the first solution is more preferably 0.5% by weight or more, still more preferably 1.0% by weight or more, and more preferably less than 4.5% by weight, still more preferably less than 4.0% by weight.

In the method for producing the photoelectric conversion element of the present invention, next, a second film forming step is performed. In this step, a second film is formed on the first film from a solution (second solution) of AX wherein A represents an organic base compound or an alkali metal and X is a halogen atom.

Forming the film of the second solution on the first film causes the first film to react with the second film, producing a perovskite compound AMX.

In the method for producing the photoelectric conversion element of the present invention, subsequently, a heating treatment step is performed.

Heating treatment increases the crystallinity of the perovskite compound, thus further improving the photoelectric conversion efficiency. The heating treatment is preferably performed at 100°C to 180°C for 1 to 15 minutes, more preferably at 120°C to 140°C for 3 to 10 minutes.

A solar cell having high photoelectric conversion efficiency can be produced using the photoelectric conversion element of the present invention.

The present invention also encompasses a solar cell including a cathode, the photoelectric conversion element of the present invention, and an anode in the stated order.

The solar cell of the present invention includes a cathode, a photoelectric conversion element, and an anode in the stated order.

The term "layer" as used herein means not only a layer having a clear boundary, but also a layer having a concentration gradient in which contained elements are gradually changed. The photoelectric conversion element herein is a layer. The elemental analysis of the layer can be conducted, for example, by FE-TEM/EDS analysis of a cross section of the solar cell to confirm the element distribution of a particular element. The term "layer" as used herein means not only a flat thin-film layer, but also a layer capable of forming an intricate structure together with other layer(s).

The material of the cathode is not limited, and may be a conventionally known material. Examples of cathode materials include fluorine-doped tin oxide (FTO), sodium, sodium-potassium alloys, lithium, magnesium, aluminum, magnesium-silver mixtures, magnesium-indium mixtures, aluminum-lithium alloys, Al/Al₂O₃ mixtures, and Al/LiF mixtures. Examples also include gold, silver, titanium, molybdenum, tantalum, tungsten, carbon, nickel, and chromium. These materials may be used alone or in combination of two or more.

The cathode may have any thickness. The lower limit of the thickness is preferably 10 nm and the upper limit thereof is preferably 1,000 nm. The cathode having a thickness of 10 nm or more can function as an electrode while having low resistance. The cathode having a thickness of 1,000 nm or less can have further improved light transmittance. The lower limit of the thickness of the cathode is more preferably 50 nm and the upper limit thereof is more preferably 500 nm.

The photoelectric conversion element may be the same as the photoelectric conversion element of the present invention.

The solar cell of the present invention may include an electron transport layer between the cathode and the photoelectric conversion element.

The electron transport layer may be formed from any material. Examples of the material include N-type conductive polymers, N-type low-molecular organic semiconductors, N-type metal oxides, N-type metal sulfides, alkali metal halides, alkali metals, and surfactants. Specific examples thereof include cyano group-containing polyphenylene vinylene, boron-containing polymers, bathocuproine, bathophenanthroline, (hydroxyquinolinato)aluminum, oxadiazole compounds, and benzoimidazole compounds. The examples further include naphthalenetetracarboxylic acid compounds, perylene derivatives, phosphine oxide compounds, phosphine sulfide compounds, fluoro group-containing phthalocyanine, titanium oxide, zinc oxide, indium oxide, tin oxide, gallium oxide, tin sulfide, indium sulfide, and zinc sulfide.

The electron transport layer may consist only of a thin-film electron transport layer. Preferably, the electron transport layer includes a porous electron transport layer. In particular, when the photoelectric conversion element is a composite film in which an organic semiconductor or inorganic semiconductor part and a perovskite compound part are combined, the composite film is preferably formed on a porous electron transport layer. This is because a more complicated composite film (more intricate structure) can be obtained, enhancing the photoelectric conversion efficiency.

The lower limit of the thickness of the electron transport layer is preferably 1 nm and the upper limit thereof is preferably 2,000 nm. When the thickness is 1 nm or more, holes can be sufficiently blocked. When the thickness is 2,000 nm or less, the layer is less likely to serve as resistance to electron transport, enhancing the photoelectric conversion efficiency. The lower limit of the thickness of the electron transport layer is more preferably 3 nm and the upper limit thereof is more preferably 1,000 nm. The lower limit is still more preferably 5 nm and the upper limit is still more preferably 500 nm.

The material of the anode is not limited, and may be a conventionally known material. Examples of the material of the anode include metals such as gold, conductive transparent materials such as CuI, indium tin oxide (ITO), SnO₂, aluminum zinc oxide (AZO), indium zinc oxide (IZO), and gallium zinc oxide (GZO), and conductive transparent polymers. These materials may be used alone or in combination of two or more thereof.

The anode may have any thickness. The lower limit of the thickness is preferably 10 nm and the upper limit thereof is preferably 1,000 nm. The anode having a thickness of 10 nm or more can function as an electrode while having low resistance. The anode having a thickness of 1,000 nm or less can have further improved light transmittance. The lower limit of the thickness of the anode is more preferably 50 nm and the upper limit thereof is more preferably 500 nm.

The solar cell of the present invention may have a hole transport layer between the photoelectric conversion element and the anode.

The hole transport layer may be formed from any material, and may contain an organic material. Examples of the material of the hole transport layer include P-type conductive polymers, P-type low-molecular organic semiconductors, P-type metal oxides, P-type metal sulfides, and surfactants. Specific examples thereof include compounds having a thiophene skeleton, such as poly(3-alkylthiophene). The examples also include conductive polymers having a triphenylamine skeleton, a poly-p-phenylenevinylene skeleton, a polyvinylcarbazole skeleton, a polyaniline skeleton, a polyacetylene skeleton, or the like. The examples further include: compounds having a phthalocyanine skeleton, a naphthalocyanine skeleton, a pentacene skeleton, a porphyrin skeleton such as a benzoporphyrin skeleton, a spirobifluorene skeleton or the like; molybdenum sulfide, tungsten sulfide, copper sulfide, and tin sulfide; fluoro group-containing phosphonic acid and carbonyl group-containing phosphonic acid; and copper compounds such as CuSCN and CuI.

The hole transport layer may partly merge with the photoelectric conversion element or disposed in the shape of a thin film on the photoelectric conversion element. The lower limit of the thickness of the hole transport layer in the shape of a thin film is preferably 1 nm and the upper limit thereof is preferably 2,000 nm. When the thickness is 1 nm or more, electrons can be sufficiently blocked. When the thickness is 2,000 nm or less, the layer is less likely to serve as resistance to electron transport, enhancing photoelectric conversion efficiency. The lower limit of the thickness is more preferably 3 nm and the upper limit thereof is more preferably 1,000 nm. The lower limit is still more preferably 5 nm and the upper limit is still more preferably 500 nm.

The solar cell of the present invention may further include a substrate or the like. The substrate is not limited, and examples thereof include transparent glass substrates made of soda-lime glass, alkali-free glass, or the like, ceramic substrates, and transparent plastic substrates.

The solar cell of the present invention may be produced by any method. An exemplary method includes forming, on the substrate, the cathode, the electron transport layer, the photoelectric conversion element, the hole transport layer, and the anode in the stated order.

### - Advantageous Effects of Invention

The present invention can provide a photoelectric conversion element having high photoelectric conversion efficiency, a method for producing the photoelectric conversion element, and a solar cell including the photoelectric conversion element.

### BRIEF DESCRIPTION OF DRAWINGS

Fig. 1 is a schematic view illustrating an exemplary crystal structure of a perovskite compound.

### DESCRIPTION OF EMBODIMENTS

The present invention is more specifically described with reference to, but not limited to, the following examples.

### (Example 1)

A 1000-nm-thick ITO film was formed as a cathode on a glass substrate, and ultrasonically washed with pure water, acetone, and methanol in the stated order, each for 10 minutes, and then dried.

On the surface of the ITO film was formed, by sputtering, a thin-film electron transport layer having a thickness of 20 nm. Furthermore, a titanium oxide paste containing titanium oxide (mixture of particles with an average particle size of 10 nm and particles with an average particle size of 30 nm) was applied to the thin-film electron transport layer by a spin coating method, whereby a porous electron transport layer having a thickness of 100 nm was formed.

Subsequently, 550 mg of lead iodide as a metal halide, lead nitrate as a metal nitrate in an amount of 0.2% by weight relative to the lead iodide, and potassium iodide as a potassium halide in an amount of 0.1% by weight relative to the lead iodide were dissolved in a solvent mixture of 1 mL of N,N-dimethylformamide (DMF) and 80 µL of dimethyl sulfoxide, whereby a first solution was prepared. A film was formed from this solution on the porous electron transport layer by a spin coating method, whereby a first film was formed. Furthermore, methylammonium iodide as an amine compound was dissolved in 2-propanol to prepare a 6% by weight solution (second solution). A film was formed from the second solution on the first film by a spin coating method, followed by heating treatment at 150°C for five minutes. Thus, a 400-nm-thick photoelectric conversion element containing a perovskite compound CH₃NH₃PbI₃, nitrate ions, and potassium was formed.

Subsequently, a 9% by weight solution of Spiro-OMETAD (produced by Merck) in chlorobenzene was applied to the photoelectric conversion element by spin coating, whereby a hole transport layer having a thickness of 200 nm was formed.

Then, on the hole transport layer was formed a 100-nm-thick gold film as an anode by vapor deposition. Thus, a solar cell was obtained in which the cathode, the electron transport layer, the photoelectric conversion element, the hole transport layer, and the anode were stacked (cathode/electron transport layer/photoelectric conversion element/hole transport layer/anode).

### (TOF-SIMS measurement)

A measurement sample consisting only of a photoelectric conversion element was prepared by the above method. The prepared sample was subjected to TOF-SIMS measurement using "TOF-SIMS5", produced by ION-TOF GmbH, with a Bi₃⁺⁺ ion gun as a primary ion source for measurement. From the obtained measurement results, the intensity ratio of a nitrate ion to an iodine ion (NO₃/I) was calculated based on the NO₃ peak and the iodine peak. Furthermore, the intensity ratio of a potassium ion to a lead ion (K/Pb) was calculated from the potassium ion peak and the lead ion peak. Table 1 shows the results. The specific TOF-SIMS conditions were as follows.
Primary ion: Bi₃⁺⁺
Ionic voltage: 25 kV
Ion current: 0.1 to 0.2 pA (pulsed current)
Mass range: 1 to 500 mass
Analyzed area: 500 µm × 500 µm (imaging)
Charging prevention: neutralization by electron irradiation Random scan mode

### (Examples 2 to 15 and Comparative Examples 3 and 4)

A solar cell was obtained as in Example 1 except that the amounts of lead nitrate and potassium iodide in the first solution were changed as shown in Table 1.

### (Comparative Examples 1 and 2)

A solar cell was obtained as in Example 1 except that no lead nitrate was used in the first solution and the amount of potassium iodide was changed as shown in Table 1.

### <Evaluation>

The solar cells obtained in the examples and comparative examples were evaluated as follows. The results are shown in Table 1.

### (Evaluation of photoelectric conversion efficiency)

A power source (model 236 produced by Keithley Instruments Inc.) was connected between the electrodes of the solar cell immediately after the production of the obtained solar cell. The photoelectric conversion efficiency was measured using a solar simulator (produced by Yamashita Denso Corp.) at an intensity of 100 mW/cm². The photoelectric conversion efficiency values of the examples and comparative examples were standardized with the photoelectric conversion efficiency of the solar cell obtained in Comparative Example 1 set as a benchmark.

**[Table 1]**

| | Photoelectric conversion element | | | | Evaluation |
|---|---|---|---|---|---|
| | Amount of PbNO₃ (% by weight) | Amount of Kl (% by weight) | NO₃/I | K/Pb | Photoelectric conversion efficiency |
| Example 1 | 0.2 | 0.1 | 0.001 | 0.2 | 1.04 |
| Example 2 | 0.4 | 0.1 | 0.005 | 0.2 | 1.08 |
| Example 3 | 0.5 | 0.1 | 0.01 | 0.2 | 1.10 |
| Example 4 | 0.6 | 0.1 | 0.05 | 0.2 | 1.06 |
| Example 5 | 0.2 | 1.5 | 0.001 | 0.8 | 1.06 |
| Example 6 | 0.2 | 1.8 | 0.001 | 0.9 | 1.07 |
| Example 7 | 0.4 | 1.8 | 0.005 | 0.9 | 1.10 |
| Example 8 | 0.6 | 1.8 | 0.05 | 0.9 | 1.12 |
| Example 9 | 0.8 | 1.8 | 0.10 | 0.9 | 1.09 |
| Example 10 | 0.2 | 3.0 | 0.001 | 1.4 | 1.08 |
| Example 11 | 0.2 | 4.0 | 0.001 | 1.8 | 1.08 |
| Example 12 | 0.2 | 5.0 | 0.001 | 2.2 | 1.03 |
| Example 13 | 0.2 | 5.5 | 0.001 | 2.4 | 1.02 |
| Example 14 | 1.3 | 1.8 | 0.15 | 0.9 | 1.06 |
| Example 15 | 1.6 | 1.8 | 0.18 | 0.9 | 1.02 |
| Comparative Example 1 | 0 | 0.1 | 0.0004 | 0.2 | 1.00 |
| Comparative Example 2 | 0 | 1.5 | 0.0004 | 0.8 | 1.01 |
| Comparative Example 3 | 2.0 | 0.1 | 0.22 | 0.2 | 0.98 |
| Comparative Example 4 | 2.5 | 0.1 | 0.25 | 0.2 | 0.90 |

### INDUSTRIAL APPLICABILITY

The present invention can provide a photoelectric conversion element having high photoelectric conversion efficiency, a method for producing the photoelectric conversion element, and a solar cell including the photoelectric conversion element.

## Claims

1. A photoelectric conversion element comprising
a perovskite compound represented by the formula AMX wherein A represents an organic base compound and/or an alkali metal, M represents a lead or tin atom, and X is a halogen atom,
the photoelectric conversion element having an intensity ratio of a nitrate ion to a halogen ion (NO₃/X) of 0.0010 or more and less than 0.2000 as determined by TOF-SIMS measurement.

2. The photoelectric conversion element according to claim 1, which has an intensity ratio of a potassium ion to a lead or tin ion (K/M) of 0.4 or more and less than 2.0 as determined by the TOF-SIMS measurement.

3. The photoelectric conversion element according to claim 1 or 2,
wherein the K/M is 0.8 or more and the NO₃/X is 0.0030 or more as determined by the TOF-SIMS measurement.

4. A method for producing the photoelectric conversion element according to claim 1, 2, or 3, comprising:
a first film forming step of forming a first film from a mixed solution (first solution) that contains a metal nitrate represented by MNO₃ wherein M is a lead or tin atom and a metal halide represented by MX wherein M is a lead or tin atom and X is a halogen atom;
a second film forming step of forming a second film on the first film from a solution (second solution) of AX wherein A represents an organic base compound or an alkali metal and X is a halogen atom; and
a step of performing heating treatment after the second film forming step.

5. The method for producing the photoelectric conversion element according to claim 4,
wherein the first solution contains a potassium halide represented by KX wherein X is a halogen atom.

6. A solar cell comprising a cathode, the photoelectric conversion element according to claim 1, 2, or 3, and an anode in the stated order.
